# EUROPEAN PATENT SPECIFICATION

(11) **EP 2 051 084 B1**
(45) Date of publication and mention of the grant of the patent: **11.04.2012**
(21) Application number: 07114042.0
(22) Date of filing: 08.08.2007
(51) Int. Cl.: G01R 15/18, G01R 15/16

(54) **Electrical quantity measuring device for energy transport lines**
Vorrichtung zur Messung einer Strommenge für Stromtransportleitungen
Dispositif de mesure de quantité électrique pour lignes de transport d'énergie

(30) Priority: 06.12.2006 IT PD20060445; 02.04.2007 IT PD20070121
(43) Date of publication of application: 22.04.2009
(73) Proprietor: S.G.E. Società Generale di Elettronica S.r.l., 35127 Padova (IT)
(72) Inventor: Berton, Mario, 35010, Vigonza (PD) (IT); Michielutti, Loris, 30030, Dolo (VE) (IT)
(74) Representative: Gallo, Luca

(56) References cited:
- WO-A-00/72027
- DE-A1- 3 707 707
- DE-A1- 4 435 864
- US-A- 4 999 571
- US-B1- 6 661 324

## Description

### Field of Application

The present invention concerns a measuring device of electrical quantities, in particular of voltage and current, for energy transport lines.

The measuring device of the invention lends itself to being advantageously employed to provide voltage and/or current values of electrical cables, in particular near pylons, for disconnectors, transformers, stations or other network equipment.

More in particular, the device of the present invention is capable of providing to fault signallers the voltage and current signals necessary for their functioning and for the prearrangement of electric line control systems.

### Prior Art

As is known in the sector of electric current distribution by means of high, medium and low voltage lines, there is increasing need to take in punctual voltage and current information, so to permit an optimal management of the line and in particular to permit an increasingly efficient identification of the fault sections by means of remote-control operated systems.

More in detail, fault detectors have an increasingly greater use today, such detectors capable of communicating with an operating centre to signal the transit of faults of various type (ground discharges, short-circuits between phases etc.). Such detectors can be provided both at disconnectors arranged on the main backbone lines and at the so-called IMS "pylon switches/disconnectors".

As is currently known, the voltage signals can already be provided by the same IMS disconnectors by means of suitable capacitive dividers.

In pylon switches/disconnectors, where they are not provided for, such signals must be taken from the line through the installation of TV voltage transformers or by means of capacitive insulators, with high costs and considerably maintenance expenses.

In order to permit detecting the line voltage in a simpler and more economic manner, numerous insulator solutions have been recently presented on the market for switch boards, transformers, disconnectors or other items, provided at their interior with at least a capacitance from which it is possible to extract a voltage signal with respect to the ground potential, through an electric connection connected at the base of the insulator and arranged passing through the interior of the metal containment station of the network equipment. Some of these solutions are for example described in the patents DE 196 44 482, DE 10000243 and EP 134 541.

In patent EP 688 075, a modulator insulator is described equipped with several axially superimposable rings so to make the desired insulation, at whose interior capacitances are prearranged which result arranged in series once the rings are stacked on each other.

The voltage signal detected is proportional to the signal to be measured and is obtained through a capacitive divider according to the known equation V=VoC1/(C1+C2) with C1 the capacitance inside the insulator, C2 the capacitance of the measuring device and Vo the phase voltage to be measured.

The latter solution does not take into consideration that in most cases the network equipment is already installed and it can hence be quite a burden to substitute it with other, new equipment equipped with insulators with capacitances integrated inside.

Moreover, one must take into account that the sulphur hexafluoride switches/disconnectors (SF6), which are currently preferred since they permit a compact assembly and considerable remote-control operation ease, are contained in a sealed metal box body, from which it is then difficult and burdensome to extract wires for the voltage measurement.

The current signals are usually drawn by means of an amperometric transformer (TA), which is preferably constituted by a current-measuring device formed by a Rogowski coil arranged coaxially with the cable and susceptible to being crossed by an induced current proportional to the variation of the current in the line cable, like the secondary circuit of a transformer, of which the primary is the line cable.

Several of these current measuring device solutions are described for example in patents EP 573 350 and WO 01/0575543.

The disadvantage of these devices for the current measurement lies in the fact that they are not capable of measuring the electric current intensity values with sufficient precision on lines of high and medium voltage in particular, since they experience disturbances due to the presence of the electrical field generated by the lines themselves.

Such electric field in fact generates a capacitive coupling, source of disturbances which influence both the TA and the electronic circuits of the same device for the processing of the signal which is found near the lines, thus rendering the measuring of the aforesaid devices little precise on bare cable.

The current and voltage measuring devices currently available on the market have shown in practice to be difficult to mount in the lines.

Moreover, the different technical needs of the two measuring devices have made their assembly almost always impossible in a single measuring device.

Document DE 4435864 discloses a socket for high-voltage power supply systems which can be equipped with a current and/or voltage sensor comprising an electrode projecting out of the cable.

Document WO 00/72027 discloses a current sensor for measuring a time-varying electrical current in a portion of a primary conductor comprising a sensor conductor having a plurality of windings connected at the end to a signal processing circuit.

Document US 6661324 discloses a voltage and current sensor comprising of a plurality of surface mounted inductors serially connected around the circumference of a current carrying conductor and a plurality of surface mounted resistors each connected in parallel with an inductor wherein an electrical circuit connected to the inductors and resistors provide a measurement of current in the conductor. The inductors and resistors are mounted on a printed circuit board that has a plated aperture for receiving the current carrying conductor there through. An electrical circuit connected to the plated aperture provides a voltage measurement.

Document US 4999571 discloses a current and voltage detector (1) for a distribution system having a lower section (2), an upper section (3) and a fastening means for combining the lower and upper sections into one body. The lower section comprises: a first groove for receiving an electric wire of the distribution system; an optical type current sensor (4); an optical type voltage sensor (5); and a potential divider for supplying a voltage to the voltage sensor. The upper section comprises: a second groove for receiving the electric wire; and a U-shaped magnetic core (6) for applying a magnetic field to the current sensor.

Document DE 3707707 discloses a measuring transducer (1) which is provided in particular for measuring on busbars and cables of power distribution networks,m and as a voltage sensor (6) which can be coupled capacitively to the busbar or the cable core and a current sensor (4) which responds to the magnetic field which surrounds the busbar or the cable core.

### Presentation of the invention

The essential object of the present invention is therefore to overcome the drawbacks manifested by the solutions of known type mentioned above by providing an electrical quantity measuring device for energy transport lines which can be easily associated with the lines, in particular in sections which are not in mechanical traction, in a simple and economic manner.

A further object of the present invention is to provide a measuring device to detect both the voltage and the current of the line cables which is not influenced by disturbances which could compromise its precision.

A further object of the present invention is to provide a measuring device which is easy to calibrate and inspect.

A further object of the present invention is to provide a measuring device which is structurally simple and economical to make and entirely reliable in operation.

### Brief description of the drawings

The technical characteristics of the present finding, according to the aforesaid objects, can be found in the contents of the claims reported below, and the advantages of the same are more evident from the following detailed description, made with reference to the attached drawings, which represent several merely exemplifying and non-limiting embodiments in which:
- **Figure 1** shows a schematic view of the section plane of the measuring device, object of the present invention;
- **Figure 2** shows the device of figure 1 in a side view;
- **Figure 3** shows a side, sectional view of an example of the device according to the present invention.
- **Figure 4** shows a plan view of a current sensor according to the present invention, with a centrally associated tubular duct;
- **Figure 5** shows an operative example of the device according to the present invention;
- **Figure 6** shows a further embodiment of the device according to the present invention;
- **Figure 7** shows a side, sectional view of the device of figure 6, taken along a longitudinal plan centred on the tubular duct;
- **Figure 8** shows a further side, sectional view of the device example of figure 6 taken along a longitudinal plan centred on the tubular duct and rotated with respect to the section plane of figure 7;
- **Figure 9** shows a view of the device of figure 6 taken axially to the tubular duct.

### Detailed description of several preferred embodiments

In accordance with the attached figures and drawings, the measuring device, object of the present finding, was indicated in its entirety with 1.

In accordance with the exemplifying embodiments illustrated in the figures, the device 1 is operatively associable with an electric line cable 3, for example three-phase with medium or high voltage, in particular for voltages of 25 or 36 KV, but can have application also in low voltages, for measuring a signal indicative of the phase voltage and/current of the line.

Advantageously, the device 1 is intended to be employed at shielded or bare line, pylons for disconnectors, transformers, aerial stations or other network equipment of any one type provided for on the market.

As will be explained more in particular below, the aforesaid device 1 is intended to be mounted not only on lines under traction but also at a flexible end, i.e. a terminal section of the line cable which is not subjected to mechanical traction, suitably provided for in the lines commonly employed for energy transport.

The device 1 according to the present invention can also be mounted by associating it with an insulator of any one equipment piece (disconnector, station etc.), without departing from the protective scope defined by the present patent.

The aforesaid device 1 comprises a device for detecting a voltage signal provided with a through capacitor 2, below and in the attached figures indicated with TV, in the form of a metal collar or metal ring arranged coaxially with the line cable 3, whose voltage must be measured.

Operatively, to detect the voltage signal, it is for example connectable to a capacitance divider of *per se* known type and thus not described in detail here.

The height H and length L of the band, or the radius of the collar, as well as the type of metal can be chosen according to requirements in order to obtain a capacitance C of the desired value.

The solution, object of the present invention moreover provides for a device for measuring a current signal on the electric line which substantially comprises a current sensor obtained with a coil susceptible to being crossed, by inductive effect, by an induced current proportional to the variation of the current in the line cable, such as the secondary circuit of a transformer, of which the primary is the line cable.

Such coil, below and also in the figures indicated with TA, is obtained on at least one printed circuit board, indicated with 4, equipped with a central opening 13.

The TA is formed by radial deposits 14 provided for on both faces of the printed circuit board and by electric connections arranged between the deposits of the two faces.

The electric connection between the deposits of the two faces is obtained by means of axial perforations 15 made through the printed circuit board which place the two faces of the circuit in communication, and a subsequent welding inside the hole thus made.

Advantageously, the TA can comprise two windings connected in series with each other and made with constant turn density in two opposite directions on a same printed circuit board, or on two separate printed circuit boards assembled in a sandwich with the interposition of an insulating material layer.

On a surface of the printed circuit board 4, electronic components 7 can be prearranged which carry out the function of conditioning the signal coming from the TA and which facilitate the subsequent acquisition and processing by the measuring instrument.

More in particular, the electric components mounted on the printed circuit board 4 can comprise integrators, diverters, amplifiers and filters adapted to condition the signal coming from the TA.

The current and voltage measurements detected by the device 1 are transmitted, preferably by means of electric cables, to a device which processes measurements and transmits possible fault signals.

The output cable of the device is equipped with flanges in epoxy/silicon resin, so to increase the creepage distance of a possible discharge.

According to the idea underlying the present invention, the device 1 moreover comprises a metal screen 6 which is advantageously placed to least partly cover the printed circuit board 4 and which permits obtaining a strong attenuation of the capacitive coupling caused by the presence of strong intensity electric fields, which would influence both the TA and the electronic components of the same device 1 for the signal processing, which are found on the printed circuit board 4 near the line.

Such metal screen 6 can be placed to totally cover the printed circuit board if it is necessary to reach particularly high measurement precision levels, or to render the device 1 little sensitive to disturbances of particularly high intensity.

The metal screen 6, in accordance with a particular embodiment, is obtained by means of a continuous metal sheet, produced from a punched metal plate, which is folded to enclose the printed circuit board 4 and subsequently sealed to make a total cover of the printed circuit board 4.

The thickness of such metal screen 6 is preferably in the range of 10 - 50 micrometres; nevertheless also different thicknesses can be employed in relation to the desired tolerances, without departing from the protective scope defined by the present patent.

Advantageously, provided for by the present measuring device solution is an insulating material layer 5 placed to at least partially cover said printed circuit board 4, interposed between the printed circuit board and the metal screen, adapted to prevent contact between the screen itself and the metal deposits which form the TA or electronic components 7 possibly present for the processing of the signal transmitted by the TA itself.

Such envisaged insulated layer 5 is formed from mica, kapton sheets or other materials capable of ensuring the electric insulation and adapted to the injection/moulding temperatures of the epoxy/silicon resins.

The insulating layer 5 can be equipped with biadhesive faces which permit its adhesion both to the surface of the metal screen and to the printed circuit board.

Advantageously, the metal screen 6 is provided with a face which bears the insulating layer 5 fixed.

The measuring device solution 1 according to the present invention furthermore provides that the TV and the TA are axially assembled and are integrally incorporated in an insulating material matrix 9 delimiting a through hole 20 for the insertion of the cable 3.

The insulating material employed for making the matrix 9 can in particular be fibre glass - reinforced plastic or epoxy/silicon resin.

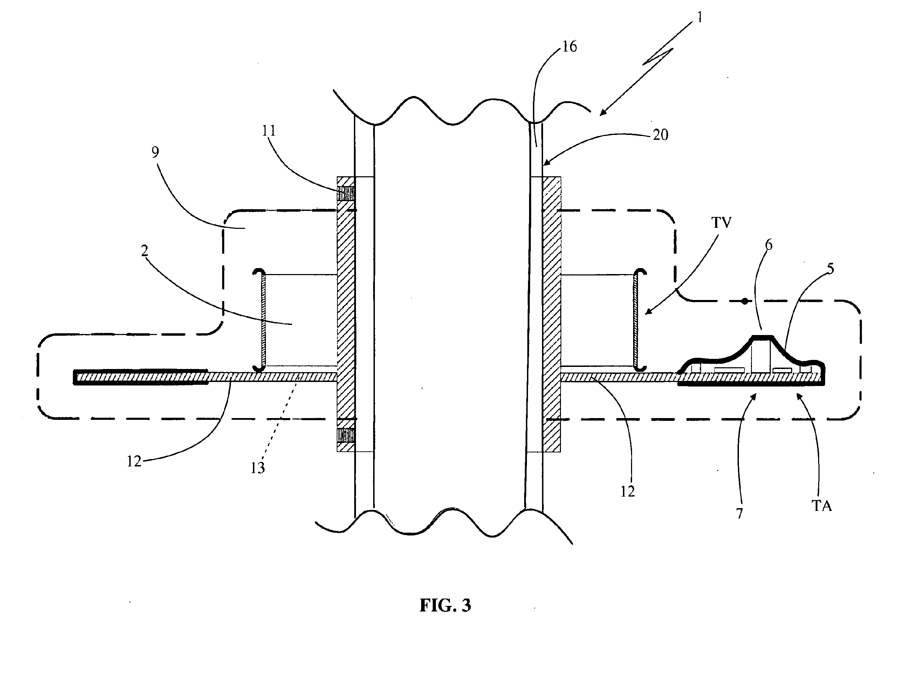

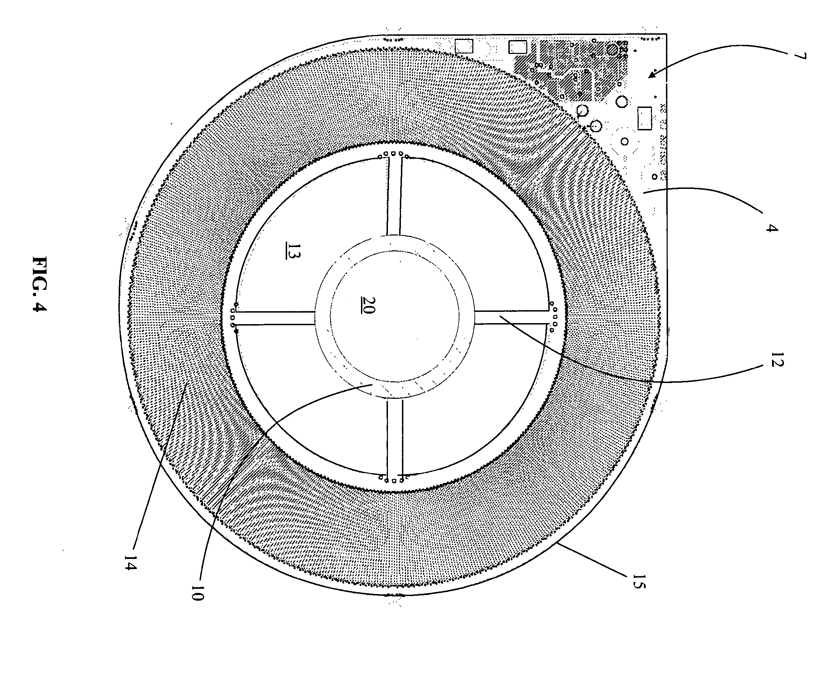

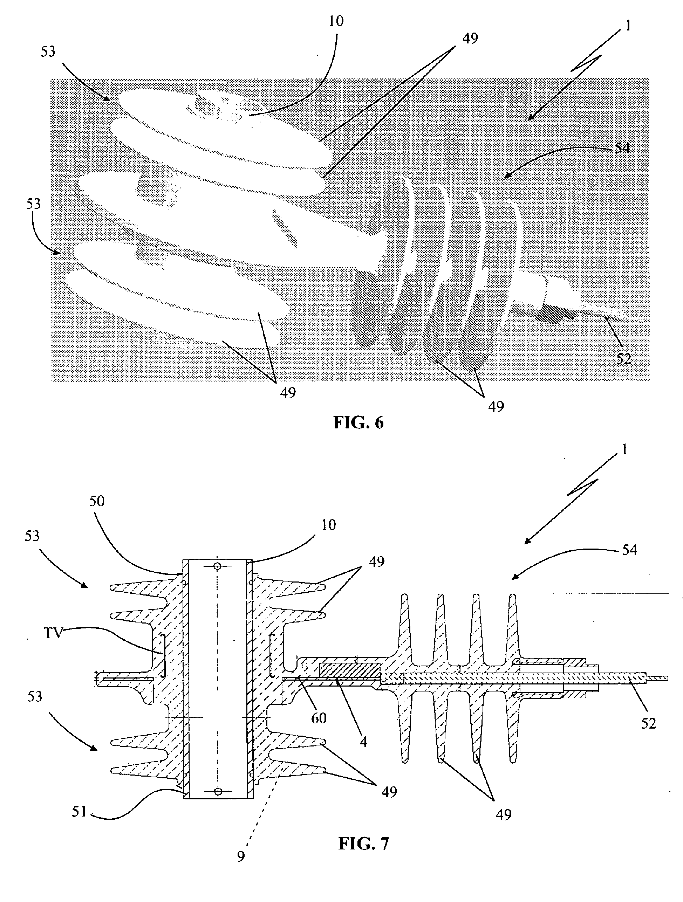

In accordance with the example of figures 3 and 4, the printed circuit board 4 has support strips 12 which extend radially from the central opening 13 of the printed circuit board towards the through hole 20, and which undertake the function of centring the TA and sustaining the TV during the injection step of the insulating matrix 9. Such strips 12 are nevertheless absent in the preferential embodiment described below and in figures 6 and 7.

The measuring device 1 in accordance with a further characteristic claimed by the present invention comprises a tubular support 10 forming an integral part of the device 1 and placed coaxial with the through hole 20 to delimit the same

The tubular support 10 is secured in position in particular during moulding by the free ends of the strips 12, which then also undertook the function of centring the tubular support 10.

The tubular support 10 permits, by means of appropriate fixing means 11, removably securing the device 1 on the cable 3 of the line to be measured, which is usually constituted by a terminal end of the line, not subject to mechanical traction, and connected to the cable under tension of a suspended line or entering network equipment.

Preferably, a piece 16 is provided for to be precisely inserted inside the tubular support 10, to which it is fixable by means of the aforesaid fixing means 11.

Such piece 16 is made in the shape of a solid cable or tube.

The fixing means can for example be provided for in the form of dowels, nevertheless different forms of fixing means can be employed without being outside the object of the present invention.

The aforesaid tubular support 10 can be made of a metal material, in which case it will be equipotential with the cable, or made of insulating material, and this case it will only be a support to the piece 16.

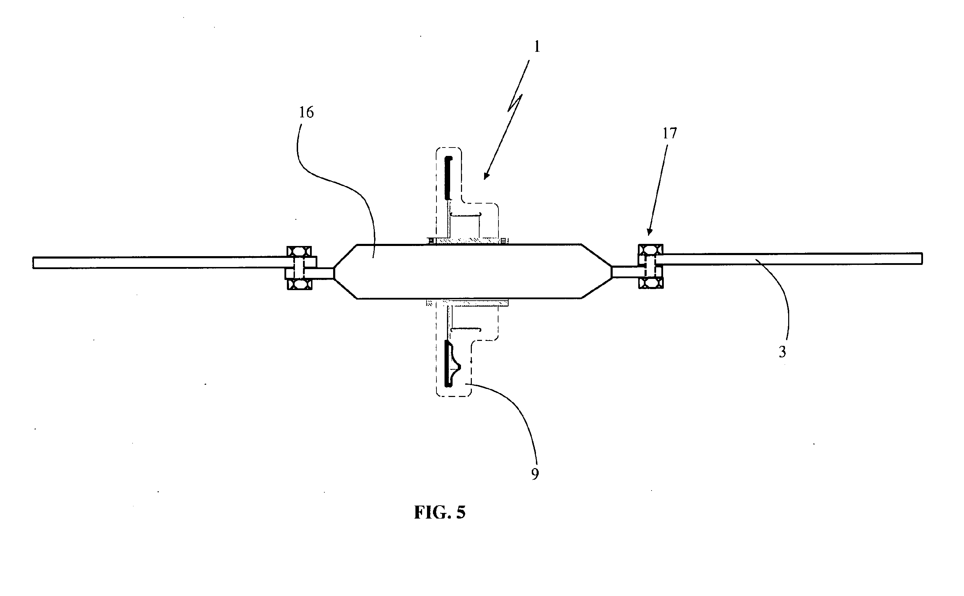

The latter is then in turn connectable to a portion under traction or not under traction of the line cable by means of fastening systems of known type such as for example by means of crimp-connector or metal band 17 (see figure 5).

The prearrangement of the tubular support 10 and piece 16 offers various advantages.

A first advantage lies in the possibility to fix the device perfectly centred on the cable under tension, since it is constituted by a piece 16 made to be precisely inserted in the tubular duct 10.

Hence, adaptations of the device for fixing to the cable under tension are not necessary, and the mechanical connection with the device 1 is particularly safe and stable.

A second advantage lies in the fact that the removability of the piece in the tubular support 10 permits facilitating the calibration and inspection operations of the device 1.

In fact, the aforesaid calibration and inspection steps require crossing the through hole 13 of the device 1 with extremely high currents (on the order of 1000 A) which can be easily obtained by inserting additional turns of a coil in the hole 20 once the piece 16 is unthreaded.

The same currents would be more difficult to produce in a single turn if the piece 16 was integrally formed with the tubular support 10.

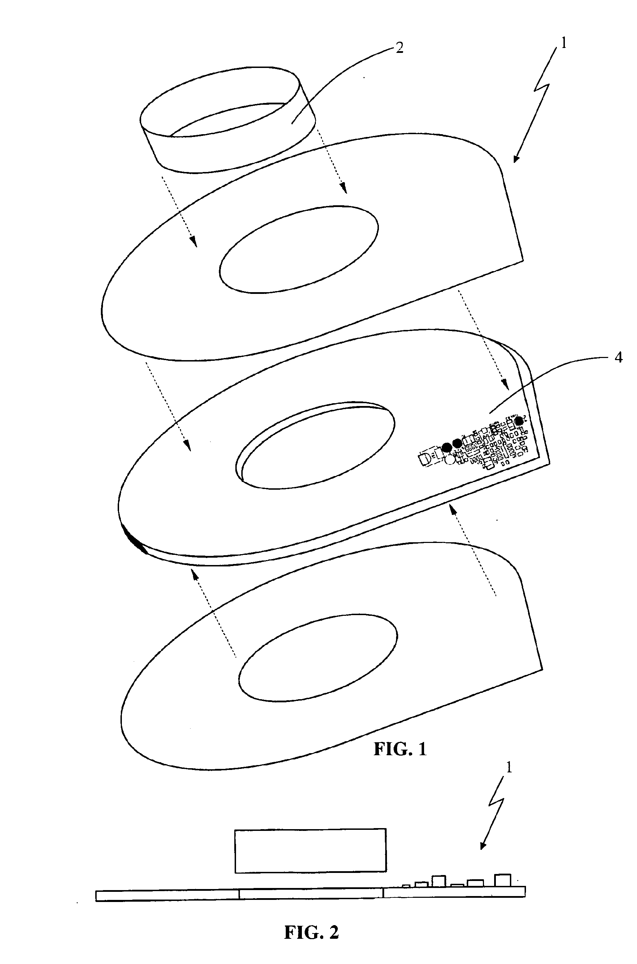

More in detail, with regard to the attached figures, according to the embodiment illustrated in figure 2 the device 1 according to the present invention comprises the through capacitor TV in the form of a metal collar 2 arranged coaxially with the cable 3, and the cable TA formed by radial deposits on the two faces of the printed circuit board 4, and by the electric connections between the deposits of the two faces.

The printed circuit board defines the central opening 13 with respect to which the electric connections which cross the printed circuit board define a greater radius circumference.

Highlighted in the figure are the following: the layer of insulating material 5 placed to cover the faces of the printed circuit board 4 and the continuous metal sheet 6 preferably placed to completely cover the printed circuit board 4 and electronic components 7, also extending to cover the circuit thickness.

Advantageously, the continuous metal sheet 6 bears the insulating material layer 5 directly fixed on one of its faces.

The printed circuit board 4 comprises the strips 12 which extend radially from the inner edge of the central opening 13 of the printed circuit board 4 towards the centre of said through hole 20 and on which the TV is directly abutted.

In accordance with this embodiment, the radius of the opening 13 of the printed circuit board 4 is greater than that of the TV.

TV and TA are integrally incorporated in the resin matrix 9.

The latter is provided with a through hole 20 with the tubular support 10 internally fixed, within which the piece 16 is coaxially fixable by means of the dowels 11.

The device 1, object of the present invention, permits being installed in a practical and easy manner (also due to the piece 16) on any one line cable for energy transmission or at terminal input portions to different electrical equipment.

The device 1, object of the present invention, permits a precise detection of the current and voltage with a single device, without the influence of disturbances due to the particular envisaged scheme.

The device 1, object of the present invention, can be easily calibrated and can be easily produced with limited costs.

Advantageously, the device 1, object of the present invention, can provide that the insulating material matrix 9 is equipped with ring flanges 49 arranged as indicated in figures 6 and 7 to increase the creepage distances of the currents which could rise as surface discharges due to the electrostatic field.

Of course, the scheme is also maintained in figures 6-9 even if not illustrated in detail.

More in detail, the creepage distances to be kept under control by means of suitable insulations are identifiable between the input 50 or output 51 of the cable 3 from the tubular support 10, and the mass of the metal screen 6 or rather the mass of the electronic circuits 7.

Furthermore, the creepage distances must be considered between the input 50 or output 51 of the cable 3 from the tubular support 10 and the electric connection wire 52 of the device 1 adapted to supply power to the device and to carry the signals.

For this purpose, two groups of first flanges 53 are provided for, placed on the sides of the printed circuit board 4 to prevent creepage with respect to the metal screen, and a second group of flanges 54 placed on the connection wire 52 of the device 1 near the printed circuit board 4 so to prevent creepage with respect to the electric connection 52.

Preferably, to compact the device 1 and for mechanical and functional reasons, the conformation of the insulating matrix 9 is of "T" shape with the rings 49 of the first groups 53 on the two branches of the T having symmetry axes orthogonal to the symmetry axis of the rings 49 of the second group 54 placed on the stem of the T.

In accordance with an advantageous embodiment variant of the present invention, no mechanical connection is provided for between the printed circuit board 4 or the TV and the tubular support 10 beyond the insulating material matrix 9. This characteristic renders the device 1 less stiff, or more elastic, and thus capable of better responding to the stress and vibrations without deformations or breaking which could give rise to reading errors. Moreover, such characteristic limits the establishment of current creepage which over time could lead to a deterioration of the insulating material 9.

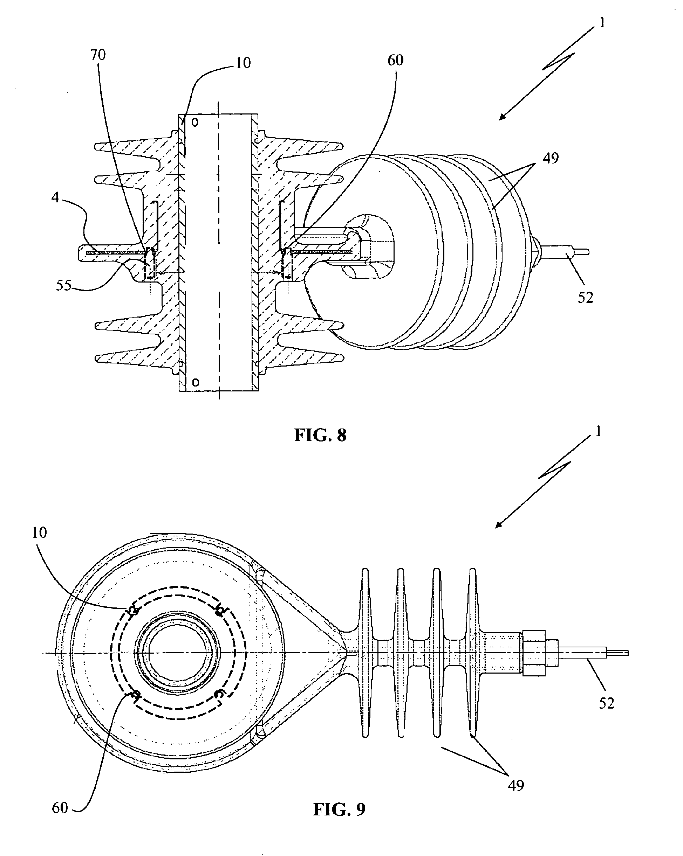

In order to avoid mechanical connection means between tubular support 10 and printed mechanical circuit 4, the latter is provided with radial extensions 60, which extend only for the length adapted to support the TV (see figure 8). In the step of moulding by means of opposite shells, one shell supports the printed circuit board 4 by means of screws engaged in plugs 55 inserted in holes 70 made on the radial extensions 60 of the printed circuit board 4, and the other shell supports the tubular support 10 in centred position with respect to the printed circuit board 4. The tubular support 10 is easily held on such mould shell due to the fact that it projects from the envisaged openings on the two shells or rather due to the fact that it is hollow.

Once the injection is carried out of the insulating material matrix 9, adapted to completely enclose the device, it is envisaged that the screws engaged in the plugs 55 are removed and the latter are covered with an insulating material layer adapted to close the hole left free by the screw.

The axial centring of the TV and TA with respect to the tubular duct is ensured without direct connection means, which would have above-described drawbacks.

It is noted that the connection wire 52 is advantageously electrically connected to the printed circuit board 4 and for such purpose it is placed aligned at its same height. Hence, the insulating material matrix 9 has an asymmetric bulge 56 to permit covering of the electronic circuits 7.

The conformation of the insulating matrix 9 thus made, preferably by means of a single moulding step, is capable of overcoming the constraints set by law in terms of insulation and in terms of tests of endurance, pulse stress and resistance to atmospheric stress (salinity, temperature, moisture etc.)

The finding according to the present invention attains the pre-established objects. Of course, it could also assume, in its practical achievement, forms and configurations which are different from that illustrated above, without departing from the present protective scope. Moreover, all details could be substituted with technically equivalent elements, and the shapes, sizes and materials employed could be of any type according to needs.

## Claims

1. Electrical quantity measuring device for energy transport lines, operatively associable with the cable of an electric line or an equipment piece thereof, comprising:
- at least one device for detecting a voltage signal (TV) provided with a capacitor (2) connectable to a capacitive divider to detect said voltage signal;
- at least one device for detecting a current signal (TA) provided with:
- at least one current sensor obtained with a coil susceptible to be crossed with current by inductance, **characterised in that**:
- said capacitor (2) is a through capacitor in the form of a metal collar arranged coaxially with said cable (3); said current sensor is made on at least one printed circuit (4) board equipped with a central opening (13), said coil being formed by radial deposits (14) provided for on both faces of the printed circuit board and by electrical connections arranged between the deposits of the two faces;
- an insulating material layer (5) being placed to be an at least partial cover of said printed circuit board (4);
- a metal screen (6) being placed to at least partially cover said printed circuit board;
- said through capacitor (2) and said coil being axially assembled and integrally incorporated in an insulating material matrix (9) delimiting a through hole (20) for the insertion of said cable (3) and **characterised in that** it also comprises a tubular support (10) coaxially fixed to the device inside said through hole (20) to delimit the same, said tubular support (10) being made of metal to be equipotential with the cable.

2. Measuring device according to claim 1, **characterised in that** said metal screen (6) completely covers the surface of said printed circuit board.

3. Measuring device according to any one of the preceding claims, **characterised in that** said metal screen (6) is obtained by means of a continuous sheet of metal material, in particular copper or aluminium.

4. Measuring device according to claim 1, **characterised in that** it comprises support strips (12) which extend radially from the inner edge of the central opening (13) of said printed circuit board (4) towards the centre of said through hole (20).

5. Measuring device according to claim 4, **characterised in that** said through capacitor abuts on said strips.

6. Measuring device according to claim 1, **characterised in that** said metal screen (6) bears said insulating material layer (9) fixed on one face.

7. Measuring device according to claim 1, **characterised in that** it comprises fixing means (11) to secure said tubular support (10) to said cable (3).

8. Device according to claim 7, **characterised in that** it comprises a piece (16) precisely housable inside said tubular support (10), to which it is firmly secured by means of said fixing means (11) and which is connectable at its ends to the cable (3) of an electric line or equipment thereof.

9. Device according to claim 8, **characterised in that** said piece (16) is of solid cable or tube form.

10. Device according to claim 1, **characterised in that** the thickness of said metal screen (6) is in the range of 20 - 50 µm.

11. Device according to claim 7, **characterised in that** said insulating material matrix (9) is equipped with ring flanges (49) to increase the creepage distances between the output (51) or input (50) of the cable (3) from the tubular support (10) and the metal screen (6) or rather the electric connection wire (52) of the device (1).

12. Device according to claim 11, **characterised in that** said insulating material matrix (9) is provided with at least two groups of first flanges (53) placed at the sides of the printed circuit board (4) to prevent creepage towards said metal screen (6).

13. Device according to claim 11, **characterised in that** said insulating material matrix is provided with at least a second group of flanges (54) placed on the connection wire (52) of the device (1) near the printed circuit board (4) to prevent creepage with respect to the electric connection.

14. Device according to claims 12 and 13, **characterised in that** the conformation of the insulating matrix is of T form with the rings of the first groups (53) having symmetry axis orthogonal to the symmetry axis of the rings of the second group (54).

15. Device according to claim 1, **characterised in that** said printed circuit board (4) is mechanically connected to said tubular support (16) only by means of said insulating material matrix (9).

16. Device according to claim 1, **characterised in that** said connection wire (52) of the device (1) is electrically connected to the printed circuit board (4), said wire (52) being placed aligned therewith.

17. Device according to claim 1, **characterised in that** said TV is supported by radial extensions (66) which extend outward from the printed circuit board (4) without connecting to said tubular duct (10).

## Patentansprüche

1. Vorrichtung zum Messen von elektrischen Größen für Energietransportleitungen, die operativ mit dem Kabel einer Elektroleitung oder eines Apparats derselben verbunden ist, umfassend:
- mindestens eine Vorrichtung zum Erfassen eines Spannungssignals (TV), versehen mit einem Kondensator (2), der an einen kapazitiven Spannungsteiler anschließbar ist, um das Spannungssignal zu erfassen;
- mindestens eine Vorrichtung zum Erfassen eines Stromsignals (TA), versehen mit:
- mindestens einem Strommessfühler, der mit einer Spule realisiert wird, durch die dank induktivem Effekt Strom fließen kann, **dadurch gekennzeichnet, dass**:
- der Kondensator (2) eine Kondensatordurchführung in Form eines koaxial an dem Kabel (3) angeordneten Metallbundes ist; der Strommessfühler auf mindestens einer Leiterplatte (4) herausgearbeitet ist, die mit einer mittigen Öffnung (13) versehen ist, wobei die Spule aus radialen Ablagerungen (14) gebildet ist, die auf beiden Seiten der Leiterplatte vorgesehen sind, sowie aus elektrischen Anschlüssen, die zwischen den Ablagerungen der beiden Seiten angeordnet sind;
- eine Schicht Isolierstoff (5) zur mindestens teilweisen Abdeckung der Leiterplatte (4) angeordnet ist;
- eine Metallblende (6) zur mindestens teilweisen Verkleidung der Leiterplatte angeordnet ist;
- wobei die Kondensatordurchführung (2) und die Spule axial zusammengebaut und zur Bildung eines Einheitskörpers in eine Matrize aus Isolierstoff (9) eingebaut sind, die das durchgehende Loch (20) zur Einführung des Kabels (3) begrenzt, und **dadurch gekennzeichnet, dass** sie ferner einen rohrförmigen Träger (10) umfasst, der koaxial an der Vorrichtung im Innern des durchgehenden Loches (20) zur Begrenzung desselben befestigt ist, wobei der rohrförmige Träger (10) zum Potentialausgleich mit dem Kabel aus einem Metallmaterial hergestellt ist.

2. Vorrichtung zum Messen nach Anspruch 1, **dadurch gekennzeichnet, dass** die Metallblende (6) die Oberfläche der Leiterplatte vollkommen verkleidet.

3. Vorrichtung zum Messen nach einem beliebigen der vorstehenden Ansprüche, **dadurch gekennzeichnet, dass** die Metallblende (6) aus einer durchgehenden Metallfolie, insbesondere aus Kupfer oder Aluminium hergestellt ist.

4. Vorrichtung zum Messen nach Anspruch 1, **dadurch gekennzeichnet, dass** sie Stützspeichen (12) umfasst, die sich radial von der Innenkante der mittigen Öffnung (13) der Leiterplatte (4) zur Mitte des durchgehenden Loches (20) hin erstrecken.

5. Vorrichtung zum Messen nach Anspruch 4, **dadurch gekennzeichnet, dass** die Kondensatordurchführung auf den Speichen aufliegt.

6. Vorrichtung zum Messen nach Anspruch 1, **dadurch gekennzeichnet, dass** die Metallblende (6) die auf einer Seite befestigte Schicht aus Isolierstoff (9) trägt.

7. Vorrichtung nach Anspruch 1, **dadurch gekennzeichnet, dass** sie Befestigungsmittel (11) zum Festhalten des rohrförmigen Trägers (10) am Kabel (3) umfasst.

8. Vorrichtung nach Anspruch 7, **dadurch gekennzeichnet, dass** sie ein auf Maß aufnehmbares Stück (16) im Innern des rohrförmigen Trägers (10) umfasst, an dem sie mittels Befestigungsmitteln (11) starr befestigt ist und welcher an seinen Enden am Kabel (3) einer Elektroleitung oder eines Apparats derselben angeschlossen werden kann.

9. Vorrichtung nach Anspruch 8, **dadurch gekennzeichnet, dass** das Stück (16) die Form eines Schlauchs oder eines Massivkabels besitzt.

10. Vorrichtung nach Anspruch 1, **dadurch gekennzeichnet, dass** die Dicke der Metallblende (6) zwischen 20 und 50 µm beträgt.

11. Vorrichtung nach Anspruch 7, **dadurch gekennzeichnet, dass** die Matrize aus Isolierstoff (9) mit einem ringförmigen Flansch (49) versehen ist, um die Kriechwege zwischen dem Eingang (50) oder dem Ausgang (51) des Kabels (3) von dem rohrförmigen Träger (10) und der Metallblende (6), bzw. dem elektrischen Verbindungsdraht (52) der Vorrichtung (1) zu erhöhen.

12. Vorrichtung nach Anspruch 11, **dadurch gekennzeichnet, dass** die Matrize aus Isolierstoff (9) mit mindestens zwei Gruppen erster Flansche (53) versehen ist, die an den Seiten der Leiterplatte (4) angebracht sind, um Kriechwege zur Metallblende (6) zu vermeiden.

13. Vorrichtung nach Anspruch 11, **dadurch gekennzeichnet, dass** die Matrize aus Isolierstoff mit mindestens einer zweiten Gruppe von Flanschen (54) versehen ist, die auf dem Verbindungsdraht (52) der Vorrichtung (1) in der Nähe der Leiterplatte (4) angeordnet sind, um Kriechwege bezogen auf den Elektroanschluss zu vermeiden.

14. Vorrichtung nach den Ansprüchen 12 und 13, **dadurch gekennzeichnet, dass** die Ausformung der Isoliermatrize T-förmig und mit den Ringen der ersten Gruppen (53) versehen ist, deren Symmetrieachse rechtwinklig zur Symmetrieachse der Ringe der zweiten Gruppe (54) steht.

15. Vorrichtung nach Anspruch 1, **dadurch gekennzeichnet, dass** die Leiterplatte (4) mit dem rohrförmigen Träger (16) nur mittels der Matrize aus Isolierstoff (9) mechanisch verbunden ist.

16. Vorrichtung nach Anspruch 1, **dadurch gekennzeichnet, dass** der Verbindungsdraht (52) der Vorrichtung (1) elektrisch mit der Leiterplatte (4) verbunden ist, wobei der Draht (52) gefluchtet angeordnet ist.

17. Vorrichtung nach Anspruch 1, **dadurch gekennzeichnet, dass** das TV von radialen Ausdehnungen (66) getragen wird, die aus der Leiterplatte (4) auskragen, ohne mit der Rohrleitung (10) verbunden zu sein.

## Revendications

1. Dispositif de mesure de grandeurs électriques pour des lignes de transport d'énergie, associable fonctionnellement au câble d'une ligne électrique ou d'un équipement de celle-ci, comprenant :
- au moins un dispositif pour détecter un signal de tension (TV) muni d'un condensateur (2) pouvant être connecté à un diviseur de tension capacitif pour détecter ledit signal de tension ;
- au moins un dispositif pour détecter un signal de courant (TA) muni de :
- au moins un capteur de courant réalisé avec une bobine susceptible d'être traversée par un courant par effet inductif, **caractérisé en ce que**:
- ledit condensateur (2) est un condensateur passant en forme de collier métallique disposé de manière coaxiale par rapport audit câble (3) ; ledit capteur de courant est réalisé sur au moins un circuit imprimé (4) muni d'une ouverture centrale (13), ladite bobine étant formée par des dépôts radiaux (14) prédisposés sur les deux faces du circuit imprimé et par des connexions électriques disposées entre les dépôts des deux faces ;
- une couche de matériau isolant (5) étant disposée comme couverture au moins partielle dudit circuit imprimé (4) ;
- un blindage métallique (6) étant placé comme revêtement au moins partielle dudit circuit imprimé ;
- ledit condensateur passant (2) et ladite bobine étant assemblée axialement et étant englobés, pour former un corps unique, dans une matrice de matériau isolant (9) délimitant un trou traversant (20) pour l'insertion dudit câble (3) et **caractérisé en ce qu'**il comprend en outre un support tubulaire (10) fixé de manière coaxiale avec le dispositif à l'intérieur dudit trou traversant (20) en délimitant celui-ci, ledit support tubulaire (10) étant réalisé en matériau métallique pour être équipotentiel avec le câble.

2. Dispositif de mesure selon la revendication 1, **caractérisé en ce que** ledit blindage métallique (6) recouvre complètement la surface dudit circuit imprimé.

3. Dispositif de mesure selon l'une quelconque des revendications précédentes, **caractérisé en ce que** ledit blindage métallique (6) est obtenu au moyen d'une feuille continue de matériau métallique, en particulier en cuivre ou en aluminium.

4. Dispositif de mesure selon la revendication 1, **caractérisé en ce qu'**il comprend des rayons de support (12) qui s'étendent radialement du bord interne de l'ouverture centrale (13) dudit circuit imprimé (4) vers le centre dudit trou traversant (20).

5. Dispositif de mesure selon la revendication 4, **caractérisé en ce que** ledit condensateur passant repose sur lesdits rayons.

6. Dispositif de mesure selon la revendication 1, **caractérisé en ce que** ledit blindage métallique (6) porte ladite couche de matériau isolant (9) fixée sur une face.

7. Dispositif selon la revendication 1, **caractérisé en ce qu'**il comprend des moyens de fixation (11) pour bloquer ledit support tubulaire (10) avec ledit câble (3).

8. Dispositif selon la revendication 7, **caractérisé en ce qu'**il comprend un tronçon (16) pouvant être à la mesure voulue à l'intérieur dudit support tubulaire (10), auquel il est fixé rigidement à l'aide desdits moyens de fixation (11) et lequel peut être connecté à ses extrémités au câble (3) d'une ligne électrique ou d'un équipement de celle-ci.

9. Dispositif selon la revendication 8, **caractérisé en ce que** ledit tronçon (16) est sous la forme d'un tube ou d'un câble plein.

10. Dispositif selon la revendication 1, **caractérisé en ce que** l'épaisseur dudit blindage métallique (6) est comprise entre 20 et 50 µm.

11. Dispositif selon la revendication 7, **caractérisé en ce que** ladite matrice de matériau isolant (9) est munie d'une collerettes annulaire (49) pour augmenter les lignes de fuite entre l'entrée (50) ou la sortie (51) du câble (3) du support tubulaire (10) et le blindage métallique (6), c'est-à-dire le fil de connexion électrique (52) du dispositif (1).

12. Dispositif selon la revendication 11, **caractérisé en ce que** ladite matrice de matériau isolant (9) est munie d'au moins deux groupes de premières collerettes (53) placés sur les côtés du circuit imprimé (4) pour éviter les lignes de fuites vers ledit blindage métallique (6).

13. Dispositif selon la revendication 11, **caractérisé en ce que** ladite matrice de matériau isolant est munie d'au moins un deuxième groupe de collerettess (54) placé sur le fil de connexion (52) du dispositif (1) à proximité du circuit imprimé (4) pour éviter les lignes de fuite par rapport à la connexion électrique.

14. Dispositif selon les revendications 12 et 13, **caractérisé en ce que** la conformation de la matrice isolante est en forme de T avec les anneaux des premiers groupes (53) ayant un axe de symétrie orthogonal à l'axe de symétrie des anneaux du deuxième groupe (54).

15. Dispositif selon la revendication 1, **caractérisé en ce que** ledit circuit imprimé (4) est relié mécaniquement audit support tubulaire (16) seulement par l'intermédiaire de ladite matrice de matériau isolant (9).

16. Dispositif selon la revendication 1, **caractérisé en ce que** ledit fil de connexion (52) du dispositif (1) est connecté électriquement au circuit imprimé (4), ledit fil (52) étant disposé aligné.

17. Dispositif selon la revendication 1, **caractérisé en ce que** ledit TV est supporté par des extensions radiales (66) qui font saillie à partir du circuit imprimé (4) sans se relier audit conduit tubulaire (10).
